Europäisches Patentamt

European Patent Office

Office européen des brevets

(11) Publication number: **0 499 294 A1**

## EUROPEAN PATENT APPLICATION

(21) Application number: **92107691.5**

(22) Date of filing: **09.09.86**

(51) Int. Cl.5: **H01L 21/203**, C30B 23/02, C30B 29/40

This application was filed on 07 - 05 - 1992 as a divisional application to the application mentioned under INID code 60.

(30) Priority: **09.09.85 JP 198878/85**
**10.09.85 JP 200872/85**
**20.09.85 JP 209753/85**

(43) Date of publication of application:
**19.08.92 Bulletin 92/34**

(60) Publication number of the earlier application in accordance with Art.76 EPC: **0 215 436**

(84) Designated Contracting States:
**DE FR GB NL**

(71) Applicant: **SUMITOMO ELECTRIC INDUSTRIES LIMITED**
**No. 15, Kitahama 5-chome, Higashi-ku**
**Osaka-shi, Osaka 541(JP)**

(72) Inventor: **Matsui, Yuichi, c/o Osaka Works of Sumitomo**
**Electric Industries, Ltd., 1-3, Shimaya 1-chome**
**Konohana-ku, Osaka-shi, Osaka-fu(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) **Method of molecular epitaxial growth of single crystal layers of compound semiconductors.**

(57) A method of molecular epitaxial growth for growing single crystal on a substrate situated in a growing chamber including the steps of: a) projecting material accommodated in a cell onto the substrate under a high vacuum; b) maintaining a temperature of the substrate after the material is applied to the substrate or maintaining a temperature after the substrate is heated up to a predetermined temperature; c) removing excessive atoms which are present to form more than 1 atomic layer so that 1 atomic layer is formed on the substrate, and d) depositing a different material on the substrate so as to form a flat layer without projection and recess.

*Fig. 9a*

*Fig. 9b*

FIELD OF THE INVENTION

The present invention relates to a method of growth of a thin film for use in a composite semiconductor, and more particularly to a method of growing crystal for providing composite semiconductor thin films for use in microwave elements, photo emissive elements and/or photo receiving elements.

DESCRIPTION OF THE PRIOR ART

Problem (1)

In the field of manufacturing high electron mobility transistor (referred to as HEMT hereinafter), it is necessary to form a thin layer of a few tens to a few hundreds of nm (hundreds to a few thousand angstroms) thickness as a channel layer.

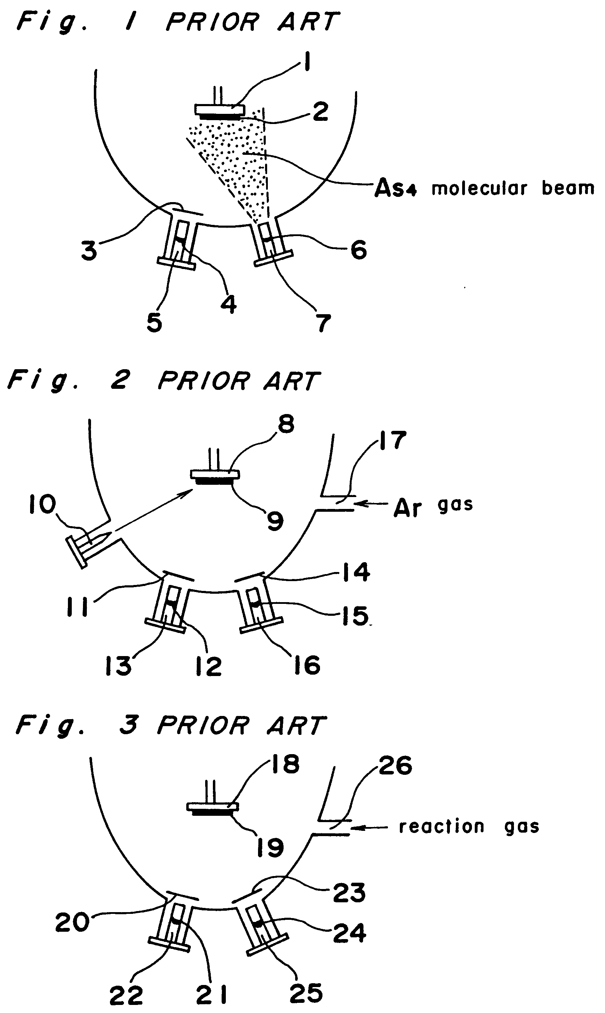

If there remain impurities on a surface of a substrate before the thin film is formed, the electric characteristic of the thin film layer formed on the substrate is lowered and the condition of the surface of the substrate appears as the characteristic of the thin film layer. In order to avoid such drawbacks, conventionally a way of thin film growth mentioned below has been employed. Figs. 1, 2 and 3 are schematic diagrams showing top plan view of an apparatus for the process of a so called molecular epitaxial growing (referred to as MBE method) in the conventional III-V composite semiconductor.

Referring to Fig. 1, 1 denotes a holder for holding a substrate 2, 3 denotes a cell shutter, 4 denotes III group sample such as Ga or In, 5 and 7 denote cells and 6 denotes V group sample such as As or P. In the method of growing III-V group composite semiconductor thin film by the conventional MBE growth, the V group elements are converted into atomic states or molecular states in the high vacuum growing chamber and radiated from the cell 7, whereby the substrate is heated up to a high temperature by illuminating light to the substrate 2 suppressing removal of the V group elements from the substrate 2 so that the impurities situated on the surface of the substrate are removed. However in the conventional method mentioned above, in order to fully remove the impurities on the substrate, it is necessary to heat the substrate up higher than a critical temperature. Heating the substrate higher than the critical temperature may cause the substrate holder 1 to be heated up to a high temperature by the heat conduction, resulting in increment of removed gas from the substrate holder 1. As a result, the background vacuum is also badly lowered thereby growing the impurities greatly and the electronic characteristic is lowered. Besides, in case after growing of the thin film on the substrate 2 and shaping of electrodes and fine shaping in the atmosphere, a top thin film layer is grown again, it is necessary to remove the impurities situated on the thin film of the lower layer. In this event, if the semiconductor chip is heated up above the critical temperature, there may occur an alloying reaction in both thin film of the lower layer and surface electrode metal, then the thin film of the lower layer is damaged. In addition, in case the lower layer is formed of multi thin layers, there occurs diffusion of the doping atoms between the two adjacent thin layers and mother atoms, thereby lowering the electronic characteristics on the interface of the thin film and the thin film per se.

Another MBE method of growing III-V group composite semiconductor thin layer is shown in Fig. 2, wherein 8 is a substrate holder, 9 is a substrate, 10 is an ion gun, 11 and 14 are cell shutters, 12 is a III group material, 13 and 16 are cells, 15 is V-group material and 17 is an entrance for Argon gas. In the method shown in Fig. 2, Ar ion beam is projected by the ion gun 10 onto the surface of the substrate 9 by introducing the Ar gas in the vacuum device, whereby the surface of the substrate 9 is cleaned off without temperature rise. However, radiation of the Ar beam causes the surface of the substrate 9 to be remarkably optically damaged and the crystal characteristic is disturbed, whereby a lot of defaults occur. As a result the crystallization and the electronic characteristic of the surface of the top layer grown on the substrate are lowered.

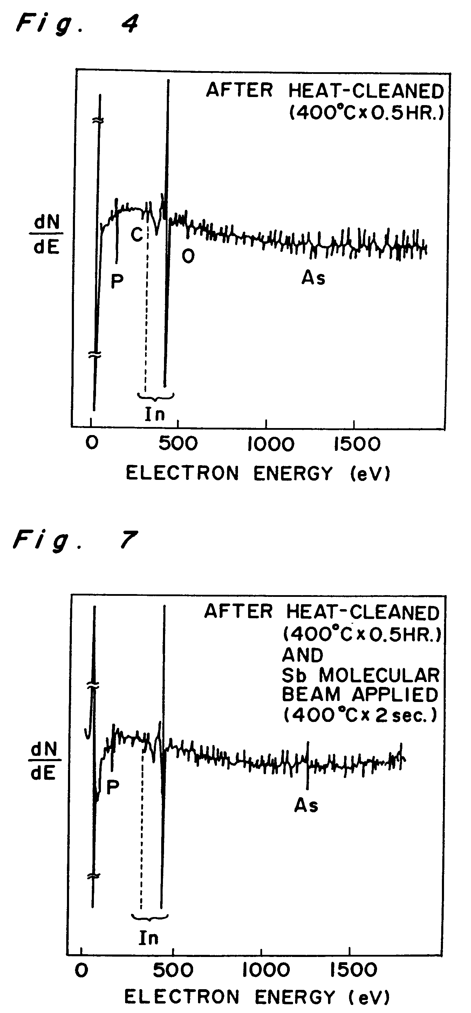

A further approach is to use so called a vapor phase epitaxial growth as the MBE method wherein there is used as shown in Fig. 3 a chemical vapor phase etching against the surface of the substrate by means of reactive gas such as HCL gas immediately before the crystal growth. In Fig. 3, 18 is a substrate holder, 20 and 23 are cell shutters, 21 is a III group material, 22 and 25 are cells, 24 is V group material and 26 is an entrance to introduce the reaction gas. In the method shown in Fig. 5, it is possible to clean the surface of the substrate without causing the substrate to be heated or damaged. However, in the method shown in Fig. 3, to introduce the reaction gas into the vacuum device causes the material forming the vacuum device and exhausting path of the vacuum device to be undesirably etched, in addition the reaction gas may reacts with fine wires such as heaters. These phenomena invite serious problems for the stable operation of the vacuum device. To etch the members of the device other than the substrate causes to generate impurity gas, thus the electronic characteristic of the III-V group composite semiconductor formed after the etching is lowered.

US-A-3 992 233 describes a method whereby Group III-V compound substrates are heat cleaned under vacuum conditions by heating above their congruent temperature about 700°C for GaAs substrate and subjecting the substrate to at least one molecular beam of the material preferentially evaporating from the substrate thereby maintaining surface stoichiometry. Surfaces so cleaned may then have an epitaxial layer grown thereon under similar conditions from molecular beams. Alternatively, the cleaned surface may be coated with cesium and oxygen to form a photocathode.

Problem (2)

There has been expected the possibility of improvement of the electric characteristics of the semiconductor device by accumulating alternative periodic construction of the growth layers of different composition each having only 1 atomic layer. Such construction is referred to as mono atomic supper lattice or MSL. This has been reported in T.Yao, J J A P 22, (1983) L 680.

The conventional method of making the MSL is to alternatively open and close the shutters 3 and 3'so as to grow the GaAs layer and AlAs layer alternatively periodically and to obtain a hetero interfaces.

However, the hetero interfaces grown by the conventional method has a disadvantage that the surface of the hetero interface is not flat but is fluctuated with more than 1 atomic thick. Such fluctuation or projection and recess of the surface of the hetero interface causes the light wave length radiated from a quantum well type light emission element to be shifted and lowering the control of the characteristic of the light emission element. Besides, in case of microwave element in which the current flows in parallel with the hetero interface such as a high electron mobility transistor (HEMT), there occurs electron scattering due to the fluctuation on the surface of the hetero interface, resulting in lowering the electron mobility and operation speed of the microwave element. Also since the surface of the hetero interface is fluctuated more than 1 atomic thick it has not been made to form the MSL on over all surface of the wafer of 2 inch diameter.

There further has been proposed to control the surface of the growth layer without the fluctuation of 1 atomic thick through observation of the growing layer by the reflection electron beam diffraction during MBE growth. (Sakamoto et al J J A P 23 (1984) L657.) However, in fact it has been impossible to suppress the fluctuation of the surface of the hetero interface even if the the above method was used. (Preliminary literature at 32 conference of applied physics 31P-ZA 12,(1985) P744.)

SUMMARY OF THE INVENTION

An essential object of the present invention is to provide a method of growth of a thin film layer in a composite semiconductor which enables to form the thin film layer having a desired characteristics.

Another object of the present invention is to provide a method of growth of a thin film layer formed by 1 atomic layer correctly without fluctuation of the surface of the thin layer.

A further object of the present invention is to provide a method of manufacturing a thin film layer of the composite semiconductor in which the high speed electron mobility can be obtained.

A still further object of the present invention is to provide a method of manufacturing a thin film layer of the composite semiconductor having only 1 atomic thick without projection and recess by an easy control of the molecular beam. According to the invention, there is provided a method of molecular epitaxial growth for growing single crystal on a substrate situated in a growing chamber including the steps of: a) projecting material accommodated in a cell onto the substrate under a high vacuum, b) maintaining a temperature of the substrate after the material is applied to the substrate or maintaining a temperature after the substrate is heated up to a predetermined temperature, c) removing excessive atoms which are present to form more than 1 atomic layer so that 1 atomic layer is formed on the substrate, and d) depositing a different material on the substrate so as to form a flat layer without projections and recesses.

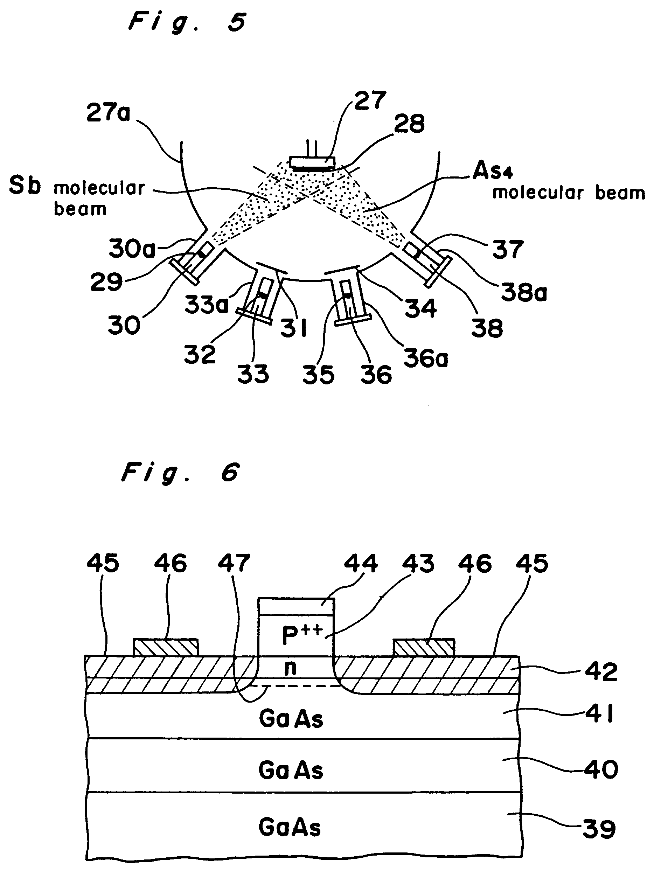

In order to solve the above problem (2), the present inventors have studied the motion of the atoms on the surface of the substrate. As the result of the observation, the following new result was discovered as shown in Fig. 8. Fig. 8 shows a result of the Auger electron spectrum analysis in the adjacent analysis chamber keeping a high vacuum with the background vacuum of $5 \times 10^{-11}$ Torr to $1 \times 10^{-10}$ Torr without taking the InP substrate out of the vacuum device after application of Ga material onto the surface of InP substrate under As pressure of $1.33 \times 10^{-4}$ to $1.33 \times 10^{-3}$Pa ($1 \times 10^{-6}$ Torr to $1 \times 10^{-5}$ Torr) at the temperature 400°C to 500°C of the substrate. The vertical axis shows the relative peak value of the Auger electron intensity taking the peak intensity of the Auger electron spectro of the InP substrate as 1,0. The horizontal axis shows the time during which radiation of Ga material with the Ga cell shutter opened. In this case it is noted that the time shown in Fig. 8 corresponds to the time from the opening of the Ga cell shutter to the closure thereof. Namely in Fig. 8, the time is plotted with the interval of about 4 to 5 seconds, and the plot corresponds to 20 seconds does not mean that the radiation of the Ga material for 4 seconds is repeated four times but means the radiation for 20 seconds of one time. As a whole, it is apparent that the longer the releasing time of the shutter or evaporation of Ga material, the weaker the intensity of the In peak. This means that the rate of detection of In Auger electron at the substrate decrease since Ga atoms are applied on the surface of the InP substrate. However, in a detail, the intensity of the peak is reduced every 15 to 16 seconds abruptly. This means the following phenomenon. For example, from 0 second to 16 second, there is no variation of the peak intensity. In other words, in case Ga cell shutter is opened only for less the 16 seconds, Ga atoms once applied to the surface of InP substrate is away from the surface of the substrate while the temperature of the substrate falls below a room temperature after the Ga cell shutter is closed during 30 minutes, then the surface of the substrate appears again. The thickness of GaAs layer when continuous growth is performed for 3 hours with the Ga molecular intensity, As pressure and the substrate temperature are kept unchanged is about 0.19 $\mu$m, therefore, the thickness of GaAs layer in case of continuous growth is 2.8 A,so that the Ga As thickness corresponds to 1 atomic thickness within the measurement error range. This phenomenon can be explained as follows.

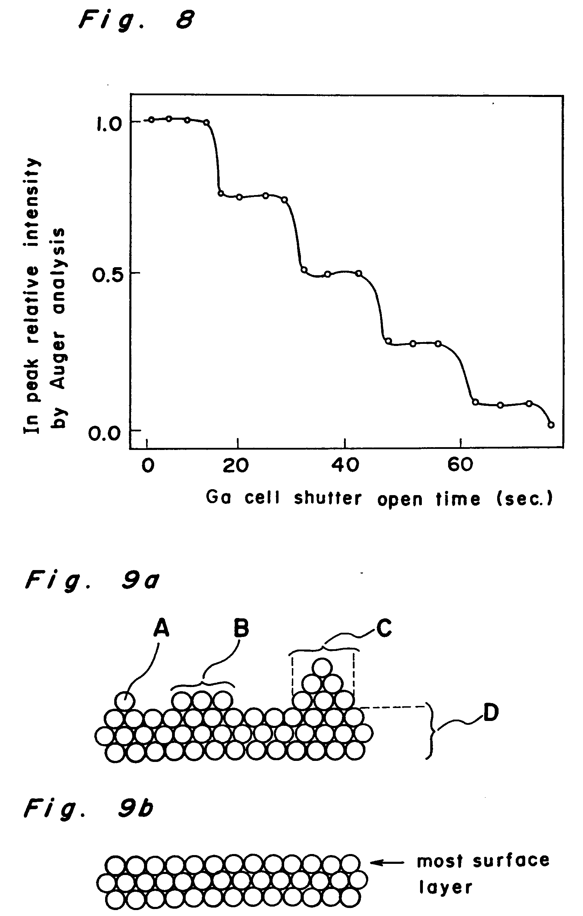

There are formed isolated atom A and two dimensional crust B and three dimensional crust C on the outermost surface of the growth layer as shown in Fig. 9a. To the contrary, the cross sectional view at the portion near the outermost surface of the growth layer having a complete flat surface can be shown as Fig. 9b with respective to the atom layer level. The atoms situated on the outermost surface are conflicted by the four most adjacent atoms by the atomic bonding force. However, the isolated atom A in Fig. 9b is conflicted only by two most adjacent atoms, and the atom in the end of the two dimensional crust B is conflicted only by three most adjacent atoms. It is noted that for the sake of brevity, the number of the most adjacent atoms are shown in Fig. 9a. In order to express correctly, it is necessary to count the number of atoms situated in the three dimensional direction (the direction perpendicular to the paper). Therefore, the force against the isolated atom A is weakest, then the force against the end of the two dimensional crust B is weak. Therefore, in order for the atom to be released from the outermost surface in Fig. 9b against the whole confliction force of the four atoms, there is required a force greater than the force to be released against the isolation atom A or two dimensional crust B. In the three dimensional crust C shown in Fig. 9a, the atoms on the top are equivalent to the isolated atom and the atoms situated in the two lower atom layers are equivalent to the two dimensional crust. Accordingly, application of the energy such as heat energy by heating with a heater or laser heating) having the amount of energy not to remove the atom form the flat surface of the atom level enables the surface to be flat as shown in Fig. 9b compared to the fluctuated surface as shown in Fig. 9a.

For this purpose there may be proposed the following two methods. One of them is to grow the layer by applying a relatively strong molecular beam heating the substrate up to such temperature as to remove only the isolated atom A, two dimensional crust B and three dimensional crust C but not to remove the atoms from the flat surface. In this case, it is necessary to supply a number of atoms greater than the number of atoms released from the substrate since the atoms tend to be removed from the substrate if the condition of the crust or isolated atom is kept long time takes a long time before 1 atomic surface is completed. Therefore a relatively great molecular beam intensity is necessary. In other words, there is needed the intensity of the molecular beam more than such necessary intensity that the scattered isolated atoms are taken in the crust, whereby the growing crust forms finally complete single atom layer. In this method, after the radiation of the molecular beam is stopped, it is possible to remove only the isolated atoms and the crust from the outermost surface by keeping the substrate at the temperature when the radiation is stopped.

The other method is to apply the molecular beam with such a temperature as not to remove the isolated atoms and crust, subsequently to stop the radiation and to heat the substrate up to such a temperature to remove the isolated atoms and crust in the outermost surface after the radiation is stopped. In this method, the temperature of the substrate is relatively low, so that the efficiency of the use of the material is high and since it is possible to decrease the intensity of the molecular beam, so that the amount of the impurity gas can be decreased. However, it is necessary to modulate the temperature of the substrate in response to the opening and closing the cell shutter.

BRIEF EXPLANATION OF THE DRAWINGS

Fig. 1 is a partial top plan view of a vacuum device used in a conventional method of growing a thin film layer of a composite semiconductor,

Fig. 2 is a a partial top plan view of a vacuum device used in another conventional method of growing a thin film layer of a composite semiconductor,

Fig. 3 is a partial top plan view of a vacuum device used in a conventional method of growing a thin film layer of a composite semiconductor,

Fig. 4 is a graph showing the peak value of the Auger electron spectra relating to a composite semiconductor, in which the vertical axis represents the value dN/dE and the horizontal axis represents the value of electron energy,

Fig. 5 is a partial plan view of a vacuum device for use in a method of the growth of thin film layer of a composite semiconductor,

Fig. 6 is a cross sectional view of a composite semiconductor,

Fig. 7 is a graph showing the peak value of the Auger electron spectra of a prior art composite semiconductor.

Fig. 8 is a graph showing the peak values of the Auger electron spectro analysis,

Figs. 9a and 9b are schematic diagram showing the condition of the atoms on the surface of the thin film layers,

Figs. 10a through 10c are respectively partial top plan view of a vacuum device used for the growth of the thin film layer according to the present invention,

Fig. 11 is graphs showing the relation between the electron mobility and the temperature in MSL according to the present invention and the conventional method,

Fig. 12 is an example of a composite semiconductor of a hetero structure formed by the method according to the present invention, and

Fig. 13 is graphs showing the relation between the electron mobility and the temperature in the hetero structure of the composite semiconductor formed by the method according to the present invention and the conventional method.

## DETAILED DESCRIPTION OF THE PREFERRED EMBODIMENTS

### Example 1

Referring to Fig. 5, a substrate holder 27 is situated at the center of a cylindrical vacuum device 27a. Placed on the front surface of the substrate holder 27 is an InP substrate. Four cylindrical cells 30, 33, 36 and 38 are disposed so as to radially project from the sylindrical wall of the vacuum device 27a and they are enclosed arm pipes 30a, 33a, 36a and 38a. Sb material 29, In material 32 of III group material, Ga material 35 and As material 37 are respectively put in the cells 30, 33, 36 and 38 which are directed toward the substrate holder 27 to radiate respective atomic beams from the materials toward the InP substrate.

In the example 1 shown in Fig. 5, InP substrate 28 was heated by the $As_4$ molecular beam up to about 400 °C for about 10 minutes keeping the vacuum of the area near the substrate with 1.33 x $10^{-4}$ to 1.33 x $10^{-3Pa}$ (1 x $10^{-6}$ Torr to 1 x $10^{-5}$ Torr) and the vacuum of the background with about 6.67 x $10^{-3Pa}$ (5 x $10^{-5}$ Torr), subsequently Sb molecular beam of about 1.33 x $10^{-6Pa}$ (1 x $10^{-8}$ Torr) was radiated to the substrate 28 for about 2 seconds. Thereafter, the cell shutter 31 of the In cell 33 and cell shutter 34 of the Ga cell 36 were opened so as to continuously grow the thin film of $In_{0.53} Ga_{0.47}$ As of 0.2 $\mu$m on the InP substrate 28. In case where 0.2 $\mu$m of $In_{0.53} Ga_{0.47}$ As was formed on the semi insulation InP substrate by means of the example 1, the electron mobility under the room temperature was 11,000 $cm^2/V$ sec and the carrier density was 1 x $10^{11}$ $cm^{-3}$. To the contrary, in case where the thin film of $In_{0.53} Ga_{0.47}$ As of 0.2 $\mu$m was formed on the InP substrate by only thermal cleaning of 400° C for 10 minutes radiating $As_4$ molecular beam of 1.33 x $10^{-3}$ Pa (1 x $10^{-5}$ Torr), the electron mobility under the room temperature was 8,000 $cm^2/V$ sec and the carrier density was 2 x $10^{16}$/cm. As apparent from the foregoing, according to the example 1, the impurity carrier density in the semiconductor can be extraordinally reduced and the electron mobility can be increased and the electric characteristics of the $In_{0.53} Ga_{0.47}$ As layer can be improved.

### Example 2

The same process as shown in the example 1 was performed except that Ga atoms were used in place of Sb atoms and III group molecular beam such as In molecular beam was used in place of Sb molecular beam. The same effect as in the example 1 could be obtained.

$In_{0.53}Ga_{0.47}$As thin layer of not more than 0.2 $\mu$m thick was made using the method of the example 2 in which In molecular beam was used in place of using Ga molecular beam. The electron mobility under the room temperature was 10500$cm^2/V$.sec., and the carrier density was 1.5 x $10^{13}$ $cm^{-3}$. In this case, it was possible to improve the electron characteristics in the thin film layer. The same effect could be recognized under the substrate temperature of 300 to 500 °C and it was possible to improve the electron characteristics of $In_{0.53}Ga_{0.47}$As thin film layer.

### Example 3

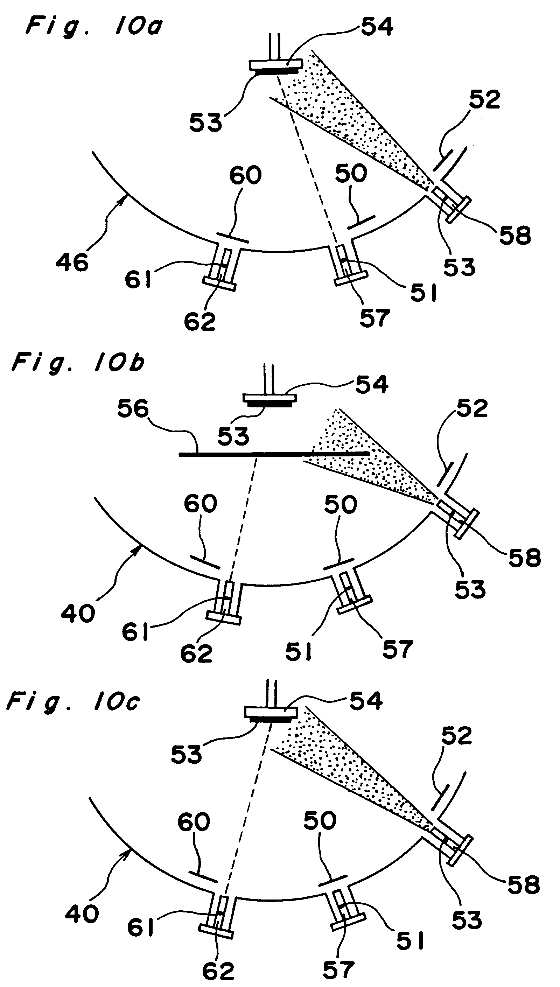

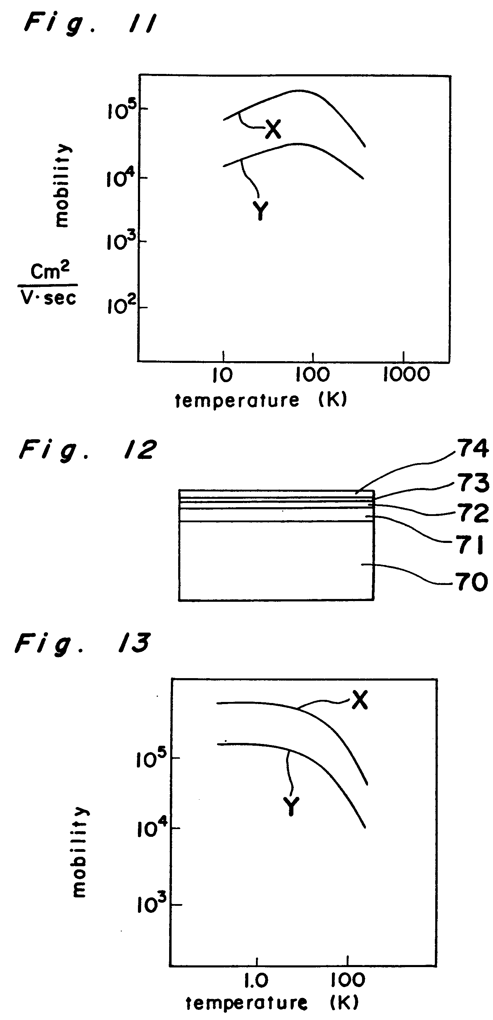

Referring to Figs. 10a to 10c, in the vacuum device 40, Ga cell shutter 50 was opened so that Ga material 51 radiated Ga molecular beam and As cell shutter 52 was opened so that As material 53 radiated As molecular beam. By the radiation of the Ga molecule beam and As molecular beam, GaAs layer was grown on the InP substrate laid on the substrate holder 54 for 20 seconds. The temperature of the substrate 53 was set at 400 °C to 500 °C. Subsequently, a main shutter 56 of a flat plate disposed in from of the substrate 53 was closed to cut off the molecular beams radiated from the cells 51 and 53. Since the directionality of Ga cell 57 and In cell 58 was keen and the spread angle of the beam was narrow, projection of the beam to the InP substrate 53 could be shut off by closing the main shutter 56. On the other hand, the directionality of the As atoms evaporated from As cell 58 was broad, therefore, some number of As atoms entered behind the main shutter even if the main shutter 56 was closed and were radiated onto the InP substrate 53. This phenomenon could give such an advantage that releasing of P atoms from the InP substrate 53 could be suppressed by the pressure of the As atoms entering behind the main shutter 56 as mentioned above, even when the InP substrate 53 was heated about 400°C to 500°C with the main shutter 56 closed. After the main shutter 56 was closed, In cell shutter 60 was opened with the Ga cell shutter 50 closed as shown in Fig. 10 b. This condition was kept for more than about 1 minute. The process mentioned above caused the excessive Ga atoms situated on the most surface of the GaAs thin layer formed on the InP substrate to be released so that a complete planar grown atomic plane could be formed. During this process, Ga cell shutter 50 was closed and In cell shutter 60 was opened, whereby radiation of the impurity gas from Ga cell shutter 50 during reheating thereof could be prevented and fluctuation of the intensity of In molecular beam at the time immediately after the opening of the cell shutter 60 could be suppressed. 61 denotes a Ga material and 62 denotes a Ga cell.

Subsequently the main shutter 56 was opened so as to repeat the growth of InAs layer on the thin GaAs layer. The same process as mentioned above was repeated for InAs layer and GaAs layer so that alternative InAs layers and GaAs layers each having mono atomic layer super lattice (MSL) were cyclicly formed.

The electric characteristics of MSL according to the present invention and MSL formed by the conventional method were compared. The result is shown in Fig 11. In Fig. 11 , the curve X shows the characteristic of MSL made using the method according to Example 3 and the curve Y shows the characteristic of MSL according to the conventional method. MSL made by the method of the present invention enables to increase the electron mobility remarkably.

A hetero structure as shown in Fig. 12 was prepared wherein each of the interfaces is formed according to the method mentioned above. Specifically, formed on the substrate 70 is a buffer layer 71 made of $Al_{0.48}In_{0.52}$ As layer 71, on which a working layer of $In_{0.53}Ga_{0.47}$ As layer , a spacer layer 73 of $Al_{0.48}In_{0.52}$ As layer and a doping layer 74 of $Al_{0.48}In_{0.52}$ As layer are respectively formed in turn. In the process of growth of the respective layers 70 to 74, the condition shown in Fig. 10 b was kept for more than 1 minutes every time the respective interfaces were formed. The temperature of the substrate 70 was kept between 400°C and 500°C. The characteristics of the hetero structure formed by the method according to the present invention and that of the hetero structure formed by the conventional method were compared. The result of comparison is shown in Fig. 13. In Fig. 13 the curve X shows the characteristic of the hetero structure according to the present invention and the curve Y shows the characteristic of the hetero structure according to the conventional method. It is understood that the electron mobility of the hetero structure formed by the method according to the present invention is higher than that of the hetero structure made by the conventional method. Field effect transistors using MSL consisting of InAs and GaAs made by the present invention and the hetero structure of $In_{0.53}Ga_{0.47}$ As and $Al_{0.48}In_{0.52}$ As were also made. They could work with a high speed.

An advantage of the present invention is to make the time of flattening the surface of the growth layer short by increasing the temperature of the InP substrate in place of keeping the temperature of the substrate constant as mentioned above.

**Claims**

1. A method of molecular epitaxial growth for growing single crystal on a substrate situated in a growing chamber including the steps of:
   a) projecting material accommodated in a cell onto the substrate under a high vacuum,
   b) maintaining a temperature of the substrate after the material is applied to the substrate or maintaining a temperature after the substrate is heated up to a predetermined temperature,
   c) removing excessive atoms which are present to form more than 1 atomic layer so that 1 atomic layer is formed on the substrate, and
   d) depositing a different material on the substrate so as to form a flat layer without projection and recess.

2. A method according to claim 1, wherein the step (d) includes depositing a smooth atomic layer of the different material in accordance with steps (a) to (c) and to repeat the above processes.

3. The method according to claim 1, wherein said substrate is InP substrate and Ga material is deposited onto the substrate to form a monoatomic layer while maintaining the InP substrate at a temperature of 300°C to 500°C in $As_4$ or $As_2$ atmosphere, subsequently the temperature of the atmosphere, subsequently the temperature of the substrate is kept between 400°C to 600°C so that the excessive Ga atoms on the surface of the monoatomic layer are removed to form a complete monoatomic GaAs layer, then the substrate temperature is kept at 250°C to 450°C and In material is deposited to more than 1 atomic thickness and the substrate temperature is kept between 400°C and 500°C to remove the excessive In atoms on the surface of the monoatomic layer and to form a complete monoatomic InAs layer and to repeat the above processes.

Fig. 1 PRIOR ART

As₄ molecular beam

Fig. 2 PRIOR ART

Ar gas

Fig. 3 PRIOR ART

reaction gas

## Fig. 4

AFTER HEAT-CLEANED
(400°C x 0.5 HR.)

$\frac{dN}{dE}$

C

P

O

As

In

ELECTRON ENERGY (eV)

## Fig. 7

AFTER HEAT-CLEANED
(400°C x 0.5 HR.)
AND
Sb MOLECULAR
BEAM APPLIED
(400°C x 2 sec.)

$\frac{dN}{dE}$

P

As

In

ELECTRON ENERGY (eV)

*Fig. 5*

*Fig. 6*

*Fig. 8*

*Fig. 9a*

*Fig. 9b*

11

Fig. 10a

Fig. 10b

Fig. 10c

*Fig. 11*

mobility

$\dfrac{Cm^2}{V \cdot sec}$

$10^5$

$10^4$

$10^3$

$10^2$

X

Y

10   100   1000

temperature (K)

*Fig. 12*

74
73
72
71
70

*Fig. 13*

mobility

X

Y

$10^5$

$10^4$

$10^3$

1.0   100

temperature (K)

13

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | US-A-4 058 430 (T. SUNTOLA ET AL.) <br> * column 2, line 5 - line 35; claims 1-8 * <br> --- | 1 | H01L21/203 <br> C30B23/02 <br> C30B29/40 |
| A | JOURNAL OF APPLIED PHYSICS. <br> vol. 54, no. 10, October 1983, NEW YORK US <br> pages 6047 - 6050; <br> M. PESSA ET AL.: 'Atomic layer epitaxy and characterization of CdTe films grown on CdTe (110) substrates.' <br> * the whole document * <br> --- | 1 | |
| A | JAPANESE JOURNAL OF APPLIED PHYSICS. <br> vol. 24, no. 6, June 1985, TOKYO JP, PAGES L417-L420 <br> H. SAKAKI ET AL.: 'One Atomic Layer Heterointerface Fluctuations in GaAs-AlAs Quantum Well Structures and Their Suppression by Insertion of Smoothing Period in Molecular Beam Epitaxy.' <br> * abstract * <br> --- | 1 | |
| D,A | US-A-3 992 233 (R.F.C. FARROW) <br> * column 1, line 14 - line 54; claims 1,2 * <br> --- | 1-3 | **TECHNICAL FIELDS SEARCHED (Int. Cl.4)** <br><br> H01L <br> C30B |
| A | US-A-3 915 765 (A.Y. CHO ET AL.) <br> * claim 1 * <br> --- | 1 | |
| A | APPLIED PHYSICS LETTERS. <br> vol. 36, no. 10, 15 May 1980, NEW YORK US <br> pages 833 - 835; <br> M.T. NORRIS: 'Composition control of GaxIn1-xAs films grown by MBE onto InP substrates.' <br> --- | | |
| A | JOURNAL OF APPLIED PHYSICS. <br> vol. 52, no. 5, May 1981, NEW YORK US <br> pages 3445 - 3452; <br> Y. KAWAMURA ET AL.: 'Improved properties of InxGa1-xAs layers grown by molecular-beam epitaxy on InP substrates.' | | |

The present search report has been drawn up for all claims

| Place of search | Date of completion of the search | Examiner |
|---|---|---|
| THE HAGUE | 12 JUNE 1992 | ZOLLFRANK G.O. |

EPO FORM 1503 03.82 (P0401)